# EUROPEAN PATENT SPECIFICATION

(11) **EP 2 908 613 B1**
(45) Date of publication and mention of the grant of the patent: **01.08.2018**
(21) Application number: 12886751.2
(22) Date of filing: 15.10.2012
(51) Int. Cl.: H05K 13/04, H05K 13/08

(54) **TAPE FEEDER COMPONENT COMPARISON SYSTEM**
VERGLEICHSSYSTEM FÜR BANDZUFÜHRUNGSKOMPONENTE
SYSTÈME DE COMPARAISON DE COMPOSANT DE DISPOSITIF D'ALIMENTATION EN BANDE

(43) Date of publication of application: 19.08.2015
(73) Proprietor: Fuji Machine Mfg. Co., Ltd., Chiryu-shi, Aichi 472-8686 (JP)
(72) Inventor: TAJIMA, Michihiko, Chiryu-shi Aichi 472-8686 (JP)
(74) Representative: Grünecker Patent- und Rechtsanwälte PartG mbB
(86) International application number: PCT/JP2012/076581
(87) International publication number: WO 2014/061072

(56) References cited:
- WO-A1-2009/087872
- JP-A- 2001 127 487
- JP-A- 2003 283 199
- JP-A- 2011 134 814
- JP-A- 2011 258 821
- US-A1- 2001 020 325
- US-A1- 2008 217 394
- US-A1- 2011 302 776

## Description

### Technical Field

The present invention relates to a tape feeder component check system that determines whether a combination of a tape feeder and a tape reel including a component which is set to the tape feeder is correct before the tape feeder is set to a component mounter.

### Background Art

In many cases, a tape feeder is used to supply a component to a component mounter which mounts components on a circuit board. The operator manually performs an operation of setting a tape reel having a component supply tape wound thereon to the tape feeder. Therefore, the operator is likely to set a tape reel including an incorrect component to the tape feeder. Therefore, before production starts (before the component mounter starts up), it is necessary to check whether the tape reel including a correct component is set to the tape feeder.

For example, PTL 1 (JP-A-11-163591) discloses a technique in which a bar code label having component identification information recorded thereon is attached to a tape reel and the operator uses a bar code reader to read the component identification information and determines whether a tape reel including a correct component is set to a tape feeder.

### Citation List

### Patent Literature

PTL 1: JP-A-11-163591
PTL 2: US 2008/217394 A1
PTL 3: US2001/0020325 A1
PTL 4: US2011/0302776 A1

PTL 2 discloses an operation support system in a component mounting apparatus on a manufacturing line for manufacturing printed board units. The operation support system comprises: an ID reading unit that reads out cassette identification information for identifying cassettes and component identification information for identifying components from the cassette, each comprising tags for recording the cassette identification information and tags for recording the component identification information. Reels are loaded on each cassette and tapes to which the components are attached are wound around the reels. One type of component is contained in one reel accommodated in the cassettes. A storage unit stores information for specifying the components previously set to be loaded on the cassettes. A component loading checking unit checks whether or not the components loaded on the cassettes are correct by comparing the component identification information with the specifying information corresponding to the cassette identification information.

The system of PTL 3 has an identification (ID) reading unit (45) that reads cassette identification information and component identification information. A memory stores information prescribing components mounted in a predetermined cassette (50).

A confirmation unit confirms whether the component (53) mounted in the cassette is correct, by comparing the component identification information with the specification information corresponding to the cassette identification information.

PTL 4 discloses an electronic-circuit assembly, which is to be carried out in an electronic-circuit assembly system, which also includes obtaining a different-property-component-related information including property-related information that enables recognition of the electrical property of the different-property component(s), which is supplied from component supplier(s), and a different-property-component supply position that is a position of the component supplier(s) supplying the different-property component (s) .

### Summary of Invention

### Technical Problem

However, among various electronic components mounted on the circuit board, there are some components in which a variation in characteristics due to manufacturing variations is not negligible. For example, even when LED elements (light emitting elements) are manufactured by the same manufacturer, the brightness of the LED element varies due to manufacturing variations. Of course, when LED elements are manufactured by different manufacturers, there are slight differences between the brightness levels of the LED elements of the same standard. Therefore, when a plurality of LED elements are mounted in a line on one circuit board, it is necessary to equalize the brightness of each LED element and to prevent a noticeable variation in the brightness of each LED element.

In order to solve the problem, the following method has been proposed. A brightness rank indicating the degree of variation in brightness due to manufacturing variations is given to each LED element. When a plurality of LED elements are mounted on one circuit board, combinations of usable brightness ranks are designated in advance by a production program (production job). During a production preparation process, the operator uses the bar code reader to read the component identification information of the tape reel, sets the tape reel to the tape feeder, and sets the tape feeder to the component mounter. At that time, communication is performed between the tape feeder and the component mounter to determine whether the brightness rank of the LED element in the tape reel set to the tape feeder is identical to the usable brightness rank designated by the production program.

However, in this method, until the operator sets the tape feeder to the component mounter, the brightness rank of the LED element supplied to the component mounter is unclear. Therefore, when the tape feeder is set to the component mounter and the brightness rank of the LED element is determined to be unusable, it is necessary to perform a time-consuming operation of detaching the tape feeder from the component mounter and replacing the tape reel. Accordingly, the production preparation time increases and the operating rate of the component mounter decreases.

An object of the invention is to provide a tape feeder component check system which can reduce the production preparation time and improve the operating rate of a component mounter.

### Solution to Problem

The invention is defined by the features of claim 1. Further embodiments are defined in the dependent claims.

In order to solve the above-mentioned problems, according to the invention, there is provided a tape feeder component check system that determines whether a combination of a tape feeder and a tape reel including a component to be set to the tape feeder is correct before the tape feeder is set to a component mounter. The tape feeder component check system includes: a component identification information recording portion which is provided in the tape reel; a database in which component data including the type, specifications, and product rank of the component and data for a product rank which can be combined with the product rank is registered so as to be associated with identification information of the component; identification information reading means for reading the identification information of the component from the component identification information recording portion; and a production management computer that receives the identification information of the component transmitted from the identification information reading means. Before an operator sets the tape feeder to the component mounter, the production management computer performs a combination determination process of reading the component data corresponding to the identification information of the component read by the identification information reading means from the database and of determining whether the product rank of the component can be combined with the product rank of another component to be mounted on the circuit board. When it is determined that the product ranks cannot be combined with each other, the production management computer notifies the operator of the determination result. Here, the "product rank" is an index indicating the degree of variation in characteristics due to manufacturing variations. For example, in the case of an LED element (light emitting element), the "product rank" is a brightness rank indicating the degree of variation in brightness due to the manufacturing variations.

In this configuration, when it is determined that the product rank of the component in the tape reel set to the tape feeder cannot be combined with the product rank of another component to be mounted on the circuit board before the operator sets the tape feeder to the component mounter, the operator is notified of the determination result. Therefore, it is possible to replace the tape reel including the component which cannot be combined before the tape feeder is set to the component mounter and thus to improve the efficiency of a production preparation operation. As a result, it is possible to reduce the production preparation time and to improve the operating rate of the component mounter.

Here, for example, a sound may be used to notify the operator that the product ranks cannot be combined with each other. Alternatively, the notice may be displayed on a display device which is provided close to the installation position of the identification information reading means or a mobile terminal of the operator. The notice may be displayed while a sound or a warning sound is output. In this case, it is possible to reliably notify the operator of the determination result.

The invention can be widely applied to a case in which a component (for example, a component with a product rank) in which a variation in characteristics due to manufacturing variations is not negligible is supplied to the component mounter. For example, it may be determined whether the product ranks (brightness ranks) of LED elements among the components to be mounted on the circuit board can be combined with each other. Alternatively, it may be determined whether the product rank (brightness rank) of the LED element and the product rank of a resistive element connected to the LED element among the components to be mounted on the circuit board can be combined with each other. The brightness of the LED element varies depending on the resistance value of the resistive element connected to the LED element. Therefore, it is possible to adjust a variation in the brightness of the LED element on the basis of the resistance value of the resistive element.

In the invention, a combination determination process may be performed on all of the components to be subjected to the combination determination process among the components to be mounted on the circuit board. When it is determined that all of the components can be combined with each other, the operator may be instructed to set the tape feeder, to which the tape reel including the component has been set, to the component mounter. According to this configuration, even when a change in the combinations is needed due to the relationship with, for example, stock components during a production preparation process, it is possible to easily respond to the change.

In the invention, the tape feeder may be provided with a feeder identification information recording portion in which identification information of the tape feeder is recorded or stored. Before the operator sets the tape feeder to the component mounter, it may be determined whether the product rank of the component supplied from the tape feeder is identical to a product rank designated by a production program on the basis of the identification information of the component and the identification information of the tape feeder which are read by the identification information reading means. When it is determined that the product rank of the component is not identical to the designated product rank, the operator may be notified of the determination result. According to this configuration, before the operator sets the tape feeder to the component mounter, it is possible to check the product rank designated by the production program.

### Brief Description of Drawings

[Fig. 1] Fig. 1 is a diagram schematically illustrating the configuration of a tape feeder component check system according to an embodiment of the invention.
[Fig. 2] Fig. 2 is a flowchart illustrating the flow of the process of a production preparation program.

### Description of Embodiments

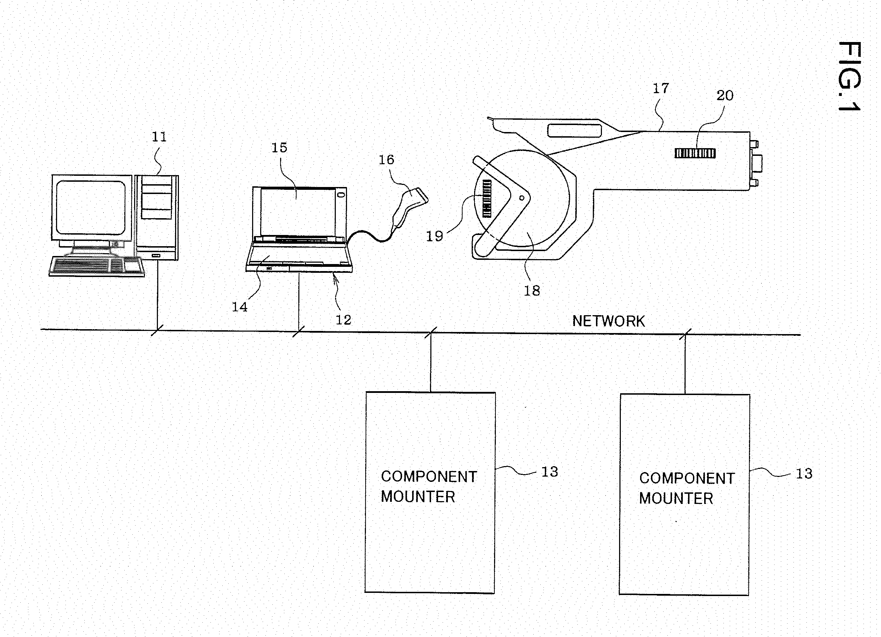

Hereinafter, an embodiment of the invention will be described. First, the overall configuration of a system will be described in brief with reference to Fig. 1.

For example, a production management computer 11 (server) which manages production in a component mounting line, an ID input personal computer 12, and component mounters 13 are connected to each other by a network. The component mounting line includes, for example, a printing device, a flux application device, an inspection device, and a reflow furnace, in addition to one or a plurality of component mounters 13.

A storage device of the production management computer 11 stores a database in which component data including the type, specifications, and product rank of a component used by the component mounter 13 and data for product ranks which can be combined with the product rank is registered so as to be associated with identification information of the component (hereinafter, referred to as a "component ID"). Here, the "product rank" is an index indicating the degree of variation in the characteristics of components, which are of the same type and have the same specifications, due to manufacturing variations. For example, in an LED element, a "brightness rank" indicating the degree of variation in brightness due to manufacturing variations is given to each LED element.

The ID input personal computer 12 includes an input device 14, such as a keyboard, a mouse, or a touch panel, a display device 15, such as a liquid crystal display or a CRT display, and a reader 16 (identification information reading means) which optically scans and reads code information such as a bar code or a two-dimensional code.

A plurality of tape feeders 17 are detachably set to the component mounter 13. A component which is supplied from each tape feeder 17 is sucked by a suction nozzle and is then mounted on a circuit board. A tape reel 18 having a component supply tape wound thereon is detachably set to each tape feeder 17. The tape reel 18 has a component ID code 19 (component identification information recording portion) such as a bar code or a two-dimensional code on which the identification information (component ID) of the component in the component supply tape is recorded. The tape feeder 17 has a feeder ID code 20 (feeder identification information recording portion) such as a bar code or a two-dimensional code on which identification information of the tape feeder 17 (hereinafter, referred to as a "feeder ID") is recorded. The component ID code 19 and the feeder ID code 20 are read by the reader 16. The read component ID and feeder ID are transmitted from the ID input personal computer 12 to the production management computer 11.

In a production preparation process, first, the operator selects the tape reel 18 including the component to be used from the stock tape reels 18 and sets the selected tape reel 18 to the tape feeder 17. At that time, before setting the tape reel 18 to the tape feeder 17, the operator uses the reader 16 to scan the component ID code 19 of the tape reel 18, transmits the read component ID from the ID input personal computer 12 to the production management computer 11, and sets the tape reel 18 to the tape feeder 17. However, after the tape reel 18 is set to the tape feeder 17, the component ID code 19 of the tape reel 18 may be read.

Before or after an operation of reading the component ID code 19 of the tape reel 18 with the reader 16, the operator uses the reader 16 to scan the feeder ID code 20 of the tape feeder 17 and transmits the read feeder ID from the ID input personal computer 12 to the production management computer 11. The production management computer 11 reads component data corresponding to the component ID read by the reader 16 from the database and performs a combination determination process of determining whether the product rank of the component can be combined with the product ranks of other components to be mounted on the circuit board. In addition, the production management computer 11 determines whether the product rank of the component supplied from the tape feeder 17 is identical to the product rank designated by a production program on the basis of the feeder ID read by the reader 16. Therefore, before the operator sets the tape feeder 17 to the component mounter 13, it is possible to check the product rank designated by the production program.

At that time, when the component to be subjected to the combination determination process is an LED element, it is determined whether the brightness ranks of the LED elements can be combined with each other. Alternatively, it may be determined whether the brightness rank of the LED element and the product rank of a resistive element connected to the LED element among the components to be mounted on the circuit board can be combined with each other. The brightness of the LED element varies depending on the resistance value of the resistive element connected to the LED element. Therefore, it is possible to adjust a variation in the brightness of the LED element on the basis of the resistance value of the resistive element.

When it is determined that as a result of the combination determination process, the brightness ranks cannot be combined with each other, information indicating the determination result is displayed on the display device 15 of the ID input personal computer 12 and is notified to the operator. However, the notice informing the operator that the brightness ranks cannot be combined with each other may be displayed on a mobile terminal of the operator or may be output as a sound. In this case, it is possible to reliably notify the operator of the determination result.

The combination determination process is performed on all of the components to be subjected to the combination determination process among the components to be mounted on the circuit board. When it is determined that all of the components can be combined with each other, the operator is instructed to set the tape feeder 17, to which the tape reel 18 including the component has been set, to the component mounter 13. This instruction may be displayed on the display device 15 of the ID input personal computer 12 or the mobile terminal or it may be output as a sound to the operator.

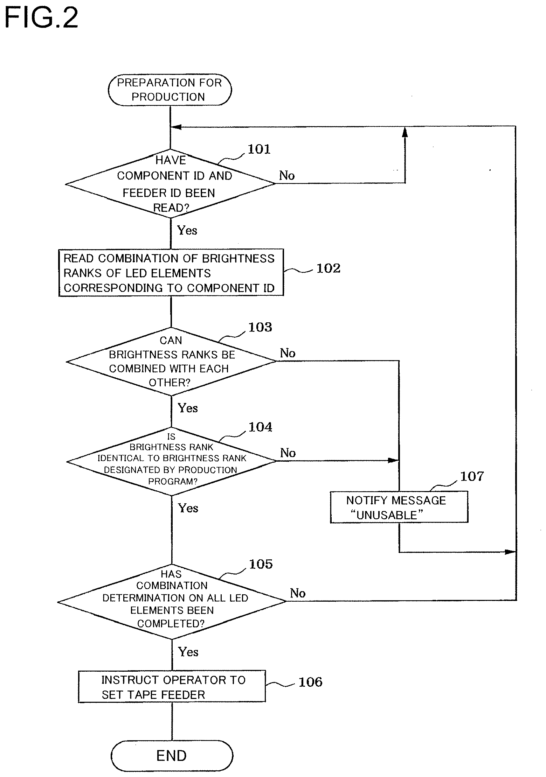

The production management computer 11 performs the production preparation process of this embodiment according to a production preparation program shown in Fig. 2. The production preparation program shown in Fig. 2 is an example of a process of determining whether the brightness ranks of the LED elements can be combined with each other. Hereinafter, the flow of the process will be described.

First, in Step 101, the operator uses the reader 16 to scan the component ID code 19 of the tape reel 18 and the feeder ID code 20 of the tape feeder 17 and determines whether the component ID and the feeder ID have been read. When the component ID and the feeder ID have not been read, the operator waits until the component ID and the feeder ID are read.

Then, when the component ID and the feeder ID have been read, the process proceeds to Step 102 and a combination of the brightness ranks of the LED elements corresponding to the read component ID is read from the database. Then, in Step 103, the combination determination process of determining whether the brightness rank of the LED element with the component ID can be combined with the brightness rank of another LED element to be mounted on the circuit board is performed. As a result, when it is determined that the brightness ranks cannot be combined with each other, the process proceeds to Step 107 and a message "unusable" is displayed on, for example, the display device 15 of the ID input personal computer 12 such that the operator is informed of the message . Then, the process returns to Step 101. When being informed of the message "unusable" , the operator replaces the tape reel 18 with another tape reel 18 and performs the above-mentioned process again.

On the other hand, when it is determined in Step 103 that the brightness ranks can be combined with each other, the process proceeds to Step 104 and it is determined whether the brightness rank of the LED element supplied from the tape feeder 17 is identical to the brightness rank designated by the production program on the basis of the feeder ID read by the reader 16. As a result, when it is determined that the brightness rank of the LED element is not identical to the brightness rank designated by the production program, the process proceeds to Step 107 and a message "unusable" is displayed on, for example, the display device 15 of the ID input personal computer 12 such that the operator is informed of the message. Then, the process returns to Step 101. When being informed of the message "unusable", the operator replaces the tape reel 18 with another tape reel 18 and performs the above-mentioned process again.

When it is determined in Step 104 that the brightness rank of the LED element supplied from the tape feeder 17 is identical to the brightness rank designated by the production program, the process proceeds to Step 105 and it is determined whether the combination determination process on all of the LED elements to be subjected to the combination determination process has been completed. When it is determined that the combination determination process has not been completed, the process returns to Step 101 and the above-mentioned process is repeated.

Then, it is determined in Step 105 that the combination determination process on all of the LED elements has been completed, the process proceeds to Step 106 and the operator is instructed to set the tape feeder 17, to which the tape reel 18 including the LED element has been set, to the component mounter 13. This instruction is displayed on, for example, the display device 15 of the ID input personal computer 12 or it may be output as a sound to the operator.

According to this embodiment, when it is determined that the product rank (brightness rank) of the component (LED element) in the tape reel 18 which is set to the tape feeder 17 cannot be combined with the product rank (brightness rank) of another component (LED element) to be mounted on the circuit board before the operator sets the tape feeder 17 to the component mounter 13, the operator is notified of the determination result. Therefore, before the tape feeder 17 is set to the component mounter 13, it is possible to replace the tape reel 18 including the component (LED element) which cannot be combined and to improve the efficiency of the production preparation operation. Therefore, it is possible to reduce a production preparation time and to improve the operating rate of the component mounter 13.

In addition, the combination determination process is performed on all of the components (LED elements) to be subjected to the combination determination process among the components (LED elements) to be mounted on the circuit board. When it is determined that all of the components (LED elements) can be combined with each other, the operator is instructed to set the tape feeder 17, to which the tape reel 18 including the component (LED element) has been set, to the component mounter 13. Therefore, even when a change in the combination is needed due to the relationship with, for example, stock components during a production preparation process, it is possible to easily respond to the change.

In this embodiment, the component ID or the feeder ID is recorded as the bar code or the two-dimensional code. However, the component ID or the feeder ID may be stored in an electronic tag (also referred to as an RF tag, a wireless tag, an IC tag, and a radio tag) and the operator may use the reader to read the component ID or the feeder ID from the electronic tag.

In addition, the invention is not limited to the brightness rank of the LED element and various modifications and changes of the invention can be made without departing from the scope of the invention. For example, the invention can be widely applied to a case in which a component (a component with the product rank) in which a variation in characteristics due to manufacturing variations is not negligible is supplied to the component mounter 13.

### Reference Signs List

11: PRODUCTION MANAGEMENT COMPUTER, 12: ID INPUT PERSONAL COMPUTER, 13: COMPONENT MOUNTER, 14: INPUT DEVICE, 15: DISPLAY DEVICE, 16: READER (IDENTIFICATION INFORMATION READING MEANS), 17: TAPE FEEDER, 18: TAPE REEL, 19: COMPONENT ID CODE (COMPONENT IDENTIFICATION INFORMATION RECORDING PORTION), 20: FEEDER ID CODE (FEEDER IDENTIFICATION INFORMATION RECORDING PORTION)

## Claims

1. A tape feeder component check system that, in a component mounting line in which a plurality of tape feeders (17) are set to a component mounter (13) and a component supplied from each tape feeder (17) is sucked by a suction nozzle and is mounted on a circuit board, is configured to determine whether a combination of the tape feeder (17) and a tape reel (18) including the component to be set to the tape feeder (17) is correct without the tape feeder (17)being set to the component mounter (13), comprising:
a component identification information recording portion (19) which is provided in the tape reel (18) and in which identification information of the component to be supplied is recorded or stored;
a database in which component data including the type, specifications, and product rank of the component and data for a product rank which can be combined with the product rank is recorded so as to be associated with the identification information, wherein the product rank is an index indicating the degree of variation in the characteristics of components of the same type and specifications due to manufacturing variations;
identification information reading means (16) that is configured to read the identification information of the component from the component identification information recording portion (19); and
a production management computer (11) that is configured to receive the identification information of the component transmitted from the identification information reading means (16),
wherein the production management computer (11) is configured to perform, without the tape feeder (17) being set to the component mounter (13), a combination determination process of reading the component data corresponding to the identification information of the component read by the identification information reading means (16) from the database and of determining whether the product rank of the component can be combined with the product rank of another component to be mounted on the circuit board, and to notify the operator of the determination result when it is determined that the product ranks cannot be combined with each other.

2. The tape feeder component check system according to claim 1,
wherein, the production management computer (11) is also configured to display the notice on a display device (15) which is provided close to an installation position of the identification information reading means (16) or a mobile terminal (12) of the operator when the production management computer (11) notifies the operator that the product ranks cannot be combined with each other.

3. The tape feeder component check system according to claim 1 or 2,
wherein the production management computer (11) is configured to determine whether the product ranks of LED elements among the components to be mounted on the circuit board can be combined with each other.

4. The tape feeder component check system according to any one of claims 1 to 3,
wherein the production management computer (11) is configured to determine whether the product ranks of the LED element and a resistive element connected to the LED element among the components to be mounted on the circuit board can be combined with each other.

5. The tape feeder component check system according to any one of claims 1 to 4,
wherein the production management computer (11) is configured to perform the combination determination process on all of the components to be subjected to the combination determination process among the components to be mounted on the circuit board, and to instruct the operator to set the tape feeder (17), to which the tape reel (18) including the component has been set, to the component mounter (13), when it is determined that all of the components can be combined with each other.

6. The tape feeder component check system according to any one of claims 1 to 5,
wherein the tape feeder (17) is provided with a feeder identification information recording portion (20) in which identification information of the tape feeder (17) is recorded or stored,
without the tape feeder (17) being set to the component mounter (13), the production management computer (11) is configured to determine whether the product rank of the component supplied from the tape feeder (17) is identical to a product rank designated by a production program on the basis of the identification information of the component and the identification information of the tape feeder (17) which are read by the identification information reading means (16), and to notify the operator of the determination result when it is determined that the product rank of the component is not identical to the designated product rank.

## Patentansprüche

1. Prüfsystem für Bandzuführung eines Bauteils, das in einer Bauteilmontagelinie, in der eine Vielzahl von Bandzuführungen (17) auf eine Bauteilmontagevorrichtung (13) eingestellt ist und ein von jeder Bandzuführung (17) zugeführtes Bauteil durch eine Saugdüse angesaugt und auf einer Leiterplatte montiert wird, konfiguriert ist, um zu bestimmen, ob eine Kombination der Bandzuführung (17) und einer Bandspule (18) einschließlich des für die Bandzuführung (17) einzustellenden Bauteils korrekt ist, ohne dass die Bandzuführung (17) auf die Bauteilmontagevorrichtung (13) eingestellt ist, das umfasst:
ein Bauteilidentifikationsinformationsaufzeichnungsteil (19), das in der Bandspule (18) bereitgestellt wird und in dem Identifikationsinformationen des zuzuführenden Bauteils aufgezeichnet oder gespeichert werden;
eine Datenbank, in der Bauteildaten einschließlich des Typs, der Spezifikationen und der Produktrangfolge des Bauteils und Daten für eine Produktrangfolge, die mit der Produktrangfolge kombiniert werden können, so aufgezeichnet werden, dass sie den Identifikationsinformationen zugeordnet sind, wobei die Produktrangfolge ein Index ist, der den Änderungsgrad der Eigenschaften von Bauteilen des gleichen Typs und Spezifikationen aufgrund von Herstellungsänderungen anzeigt;
eine Identifikationsinformationsleseeinrichtung (16), die konfiguriert ist, um die Identifikationsinformationen des Bauteils aus dem Bauteilidentifikationsinformationsaufzeichnungsteil (19) zu lesen; und
einen Produktionsmanagementcomputer (11), der konfiguriert ist, um die Identifikationsinformationen des Bauteils zu empfangen, die von der Identifikationsinformationsleseeinrichtung (16) gesendet werden,
wobei der Produktionsmanagementcomputer (11) konfiguriert ist, um, ohne dass die Bandzuführung (17) auf die Bauteilmontagevorrichtung (13) einstellt wird, einen Kombinationsbestimmungsprozess zum Lesen der Bauteildaten entsprechend den Identifikationsinformationen des Bauteils, die von der Identifikationsinformationsleseeinrichtung (16) aus der Datenbank gelesen werden, und zum Bestimmen durchzuführen, ob die Produktrangfolge des Bauteils mit der Produktrangfolge eines anderen auf der Leiterplatte zu montierenden Bauteils kombiniert werden kann, und dem Bediener das Bestimmungsergebnis mitzuteilen, wenn bestimmt wird, dass die Produktrangfolgen nicht miteinander kombiniert werden können.

2. Prüfsystem für Bandzuführung eines Bauteils nach Anspruch 1,
wobei der Produktionsmanagementcomputer (11) außerdem konfiguriert ist, um die Meldung auf einer Anzeigevorrichtung (15) anzuzeigen, die nahe einer Installationsposition der Identifikationsinformationsleseeinrichtung (16) oder eines mobilen Endgeräts (12) des Bedieners bereitgestellt wird, wenn der Produktionsmanagementcomputer (11) dem Bediener meldet, dass die Produktrangfolgen nicht miteinander kombiniert werden können.

3. Prüfsystem für Bandzuführung eines Bauteils nach Anspruch 1 oder 2,
wobei der Produktionsmanagementcomputer (11) konfiguriert ist, um zu bestimmen, ob die Produktrangfolgen von LED Elementen unter den auf der Leiterplatte zu montierenden Bauteilen miteinander kombiniert werden können.

4. Prüfsystem für Bandzuführung eines Bauteils nach einem der Ansprüche 1 bis 3,
wobei der Produktionsmanagementcomputer (11) konfiguriert ist, um zu bestimmen, ob die Produktrangfolgen des LED Elements und eines mit dem LED Element verbundenen Widerstandselements unter den auf der Leiterplatte zu montierenden Bauteilen miteinander kombiniert werden können.

5. Prüfsystem für Bandzuführung eines Bauteils nach einem der Ansprüche 1 bis 4,
wobei der Produktionsmanagementcomputer (11) konfiguriert ist, um den Kombinationsbestimmungsprozess an allen Bauteilen durchzuführen, die dem Kombinationsbestimmungsprozess unter den auf der Leiterplatte zu montierenden Bauteilen unterzogen werden sollen, und den Bediener anzuweisen, die Bandzuführung (17), auf die die Bandspule (18) einschließlich des Bauteils eingestellt wurde, auf die Bauteilmontagevorrichtung (13) einzustellen, wenn bestimmt wird, dass alle Bauteile miteinander kombiniert werden können.

6. Prüfsystem für Bandzuführung eines Bauteils nach einem der Ansprüche 1 bis 5,
wobei die Bandzuführung (17) mit einem Zuführungsidentifikationsinformationsaufzeichnungsteil (20) bereitgestellt wird, in dem Identifikationsinformationen der Bandzuführung (17) aufgezeichnet oder gespeichert werden,
ohne dass die Bandzuführung (17) auf die Bauteilmontagevorrichtung (13) eingestellt wird, der Produktionsmanagementcomputer (11) konfiguriert ist, um zu bestimmen, ob die Produktrangfolge des von der Bandzuführung (17) zugeführten Bauteils mit einer Produktrangfolge identisch ist, die durch ein Produktionsprogramm auf der Basis der Identifikationsinformationen des Bauteils und der Identifikationsinformationen der Bandzuführung (17) festgelegt wird, die von der Identifikationsinformationsleseeinrichtung (16) gelesen werden, und dem Bediener das Bestimmungsergebnis zu melden, wenn bestimmt wird, dass die Produktrangfolge des Bauteils mit der festgelegten Produktrangfolge nicht identisch ist.

## Revendications

1. Système de contrôle de composant de chargeur de bande qui, sur une chaîne de montage de composants sur laquelle une pluralité de chargeurs de bande (17) sont réglés pour un monteur de composant (13) et un composant fourni par chaque chargeur de bande (17) est aspiré par une buse d'aspiration et est monté sur une carte de circuit, est configuré pour déterminer si une combinaison du chargeur de bande (17) et d'une bobine de bande (18) incluant le composant à régler pour le chargeur de bande (17) est ou non correcte sans que le chargeur de bande (17) ne soit défini pour le monteur de composant (13), comprenant :
une partie d'enregistrement d'informations d'identification de composant (19) qui est fournie sur la bobine de bande (18) et dans laquelle des informations d'identification du composant à fournir sont enregistrées ou stockées ;
une base de données dans laquelle des données de composant incluant les type, spécifications et classement de produit du composant et des données pour un classement de produit qui peuvent être combinées avec le classement de produit sont enregistrées de sorte à être associées aux informations d'identification, dans lequel le classement de produit est un index indiquant le degré de variation dans les caractéristiques de composants des mêmes type et spécifications du fait de variations de fabrication ;
un moyen de lecture d'informations d'identification (16) qui est configuré pour lire les informations d'identification du composant à partir de la partie d'enregistrement d'informations d'identification de composant (19) ; et
un ordinateur de gestion de production (11) qui est configuré pour recevoir les informations d'identification du composant émises par le moyen de lecture d'informations d'identification (16),
dans lequel l'ordinateur de gestion de production (11) est configuré pour effectuer, sans que le chargeur de bande (17) ne soit réglé pour le monteur de composant (13), un processus de détermination de combinaison de lecture des données de composant correspondant aux informations d'identification du composant lues par le moyen de lecture d'informations de composant (16) à partir de la base de données et de détermination de la possibilité de combiner ou non le classement de produit du composant avec le classement de produit d'un autre composant à monter sur la carte de circuit, et pour notifier l'opérateur du résultat de détermination lorsqu'il est déterminé que les classements de produit ne peuvent pas être combinés l'un avec l'autre.

2. Le système de contrôle de composant de chargeur de bande selon la revendication 1,
dans lequel l'ordinateur de gestion de production (11) est également configuré pour afficher la notification sur un dispositif d'affichage (15) qui est installé à proximité d'une position d'installation du moyen de lecture d'informations d'identification (16) ou un terminal mobile (12) de l'opérateur lorsque l'ordinateur de gestion de production (11) notifie l'opérateur que les classements de produit ne peuvent pas être combinés l'un avec l'autre.

3. Le système de contrôle de composant de chargeur de bande selon la revendication 1 ou 2,
dans lequel l'ordinateur de gestion de production (11) est configuré pour déterminer si les classements de produit des éléments DEL parmi les composants à monter sur la carte de circuit peuvent être combinés l'un avec l'autre.

4. Le système de contrôle de composant de chargeur de bande selon l'une quelconque des revendications 1 à 3,
dans lequel l'ordinateur de gestion de production (11) est configuré pour déterminer si les classements de produit de l'élément DEL et d'un élément résistif connecté à l'élément DEL parmi les composants à monter sur la carte de circuit peuvent être combinés l'un avec l'autre.

5. Le système de contrôle de composant de chargeur de bande selon l'une quelconque des revendications 1 à 4,
dans lequel l'ordinateur de gestion de production (11) est configuré pour appliquer le processus de détermination de combinaison à tous les composants à être sujets au processus de détermination de combinaison parmi les composants à monter sur la carte de circuit, et pour signifier à l'opérateur de régler le chargeur de bande (17), pour lequel la bobine de bande (18) incluant le composant a été réglée, pour le monteur de composant (13), lorsqu'il est déterminé que tous les composants peuvent être combinés les uns avec les autres.

6. Le système de contrôle de composant de chargeur de bande selon l'une quelconque des revendications 1 à 5,
dans lequel le chargeur de bande (17) est doté d'une partie d'enregistrement d'informations d'identification de chargeur (20) dans laquelle des informations d'identification du chargeur de bande (17) sont enregistrées ou stockées,
sans que le chargeur de bande (17) ne soit réglé sur le monteur de composants (13), l'ordinateur de gestion de production (11) est configuré pour déterminer si le classement de produit du composant fourni par le chargeur de bande (17) est ou non identique à un classement de produit désigné par un programme de production selon les informations d'identification du composant et les informations d'identification du chargeur de bande (17) qui sont lues par le moyen de lecture d'informations d'identification (16), et pour notifier l'opérateur du résultat de détermination lorsqu'il est déterminé que le classement de produit du composant n'est pas identique au classement de produit désigné.
